# EUROPEAN PATENT APPLICATION

(11) **EP 1 324 345 A1**
(43) Date of publication of application: **02.07.2003**
(21) Application number: 01830808.0
(22) Date of filing: 27.12.2001
(51) Int. Cl.: G11C 16/24

(54) **Single supply voltage, nonvolatile memory device with cascoded column decoding**

(71) Applicant: STMicroelectronics S.r.l., 20041 Agrate Brianza (Milano) (IT)
(72) Inventor: Khouri, Osama, 20146 Milano (IT); Bedeschi, Ferdinando, 74100 Taranto (IT)
(74) Representative: Cerbaro, Elena, Dr.

(57) **Abstract**

A nonvolatile memory device (1') is described comprising a memory array (2), a row decoder (3) and a column decoder (4) for addressing the memory cells (7) of the memory array (2), and a biasing stage (13,19) for biasing the drain terminal of the addressed memory cell (7). The biasing stage (13,19) is coupled between the column decoder (4) and the memory array (2) and comprises a biasing transistor (13) having a drain terminal connected to the column decoder (4), a source terminal connected to the drain terminal of the addressed memory cell (7), and a gate terminal receiving a driving signal of a logic type, the logic levels whereof are defined by precise and stable voltages and are generated by a first driving circuit (19) formed by a driving stage (20) and a buffer (21), cascade-connected.

## Description

The present invention relates to a single supply voltage, nonvolatile memory device with cascoded column decoding.

As is known, nonvolatile memory devices comprise a memory array formed by memory cells arranged in rows and columns, wherein word lines connect the gate terminals of the cells arranged on a same row and bit lines connect the drain terminals of the cells arranged on one and the same column.

Individual rows of the memory array are addressed by a row decoder which receives an encoded address and biases the word line of the row being addressed at a stable and precise voltage, the value whereof depends upon the operation to be performed (read, program, verify, erase), while individual columns of the memory array are addressed by a column decoder which receives the above encoded address and biases the bit line of the column being addressed at a voltage such as to ensure that the drain terminal of the memory cell addressed is biased at a preset electrical potential, typically 1 V; this potential must be precise, stable and controlled since its precision affects not only the precision of the levels programmed in the memory cells, but also the programming time of the memory cells.

It is moreover known that nonvolatile memory devices have typically a single supply voltage type; namely, they receive from outside a single supply voltage currently having a value of 3 V ±10% or else 1.8 V ±10%; hence voltages having much higher values than the supply voltages and required in the various operations performed on the memory cells (read, program, verify, erase) are generated inside the nonvolatile memory device by voltage boosting circuits, generally known as "voltage boosters" or "charge pumps".

The boosted voltages supplied by voltage boosting circuits are, however, generally far from stable, and consequently are regulated and stabilized by voltage regulators.

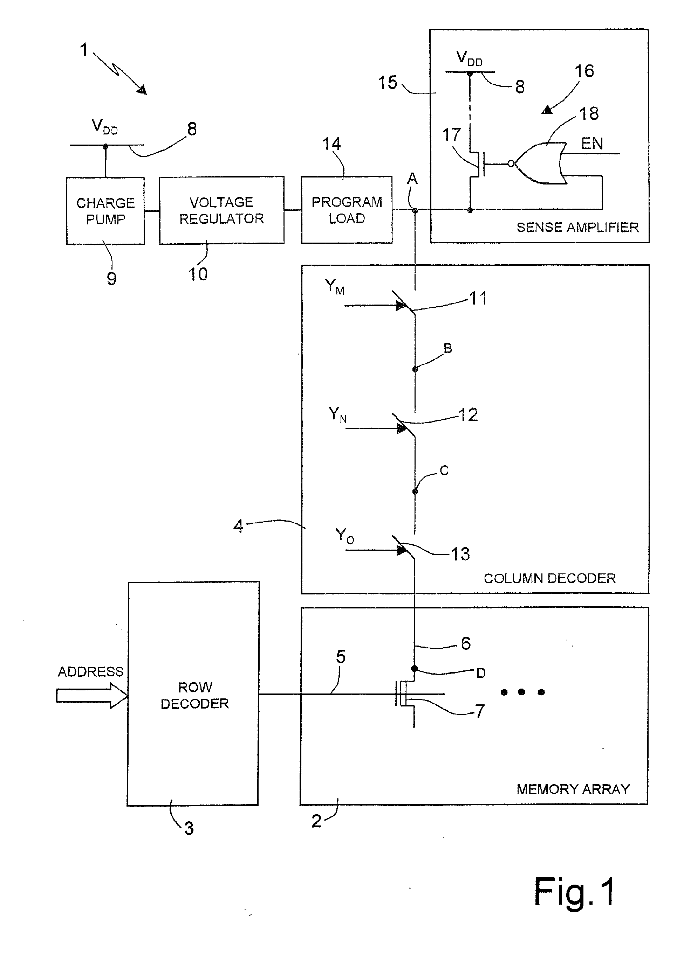

Figure 1 is a schematic illustration of a nonvolatile memory device of a known type, whereof only the parts necessary for understanding the problematic to be solved by the present invention are shown.

In particular, in Figure 1, reference number 1 designates a nonvolatile memory device as a whole, 2 designates the memory array, 3 designates the row decoder, 4 designates the column decoder, 5 designates the addressed word line, 6 the addressed bit line, 7 the addressed memory cell, 8 designates a supply line set at the supply voltage V_{DD} supplied from outside to the non volatile memory device 1, 9 designates the charge pump, having an input connected to the supply line 8 and supplying a boosted voltage higher than the supply voltage V_{DD}, and 10 designates the voltage regulator, which receives the boosted voltage and supplies a regulated voltage, which is supplied to the column decoder 4 in the programming step.

In particular, the column decoder 4 can be schematically represented by a plurality of selection switches implemented by NMOS or PMOS transistors, connected in series and receiving on their control terminals respective column decoding signals. The number of selection switches forming the column decoder 4 depends upon the size of the memory array 2 or of the sectors of the memory array and upon the hierarchical organization of the column selectors. Figure 1 illustrates by way of example a column decoder 4 formed by three selection switches, designated by 11, 12 and 13, which receive on their control terminals respective column decoding signals YM, YN and YO.

A selection stage 14, known as "program load" is further coupled between the voltage regulator 10 and the column decoder 4 and is essentially formed by a controlled switch that connects the three selection transistors 11, 12, 13 of the column decoder 4 to the output of the voltage regulator 12 only during programming for biasing the addressed bit line 6 at a voltage such as to ensure that the drain terminal of the addressed memory cell 7 is supplied with a preset electrical potential, typically of approximately 4 V or 0 V, according to whether the datum that is to be programmed in the memory cell 7 addressed is "0" or "1".

During reading, instead, the selection stage 14 disconnects the charge pump 9 and the voltage regulator 10 from the column decoder 4, the three selection elements 11, 12, 13 whereof are thus connected to the output of a read circuit or "sense amplifier" 15, which, as known, carries out reading of the contents of the addressed memory cell 7 by comparing the current flowing in the addressed memory cell 7 (or a quantity correlated thereto) with the current flowing through a reference memory cell (not shown) having known contents.

For a more detailed treatment of a circuit structure of a sense amplifier, see for example European patent application 99830348.1 filed on 4.6.1999 in the name of the present applicant and published as EP-A-1058270.

As described in the above patent application, the sense amplifier 15 comprises, among others, a biasing stage 16 having a negative fedback cascode structure for biasing the addressed bit line 6 at a voltage such as to ensure that, during reading, a preset electrical potential, typically approximately 1 V, will be present on the drain terminal of the addressed memory cell 7.

In particular, the biasing stage 16 comprises an NMOS transistor 17 and a NOR logic gate 18. The NMOS transistor 17 has its drain terminal connected to the supply line 8 set at the supply voltage V_{DD}, which is supplied from outside to the nonvolatile memory device 1, its source terminal connected to the column decoder 4, and its gate terminal connected to the output of the NOR logic gate 18; NOR logic gate 18 has a first input connected to the source terminal of the NMOS transistor 17 and a second input receiving a logic-type enabling signal EN, that allows the biasing stage 16, and consequently the sense amplifier 15, to be turned on and off.

In Figure 1, moreover, A designates the input node of the column decoder 4, connected, during reading, to the sense amplifier 15 and, during programming, to the output of the voltage regulator through the selection stage 14, B designates the node between the first NMOS transistor 11 and the second NMOS transistor 12 of the column decoder 4, C designates the node between the second NMOS transistor 12 and the third NMOS transistor 13 of the column decoder 4, and D designates the drain terminal of the addressed memory cell 7.

From an analysis of the column decoding architecture shown in Figure 1, it may be immediately understood that the voltage on the node D is equal to the voltage present on the node A minus the three voltage drops on the selection switches 11, 12 and 13 that form the column decoder 4, which are in turn proportional to the series resistances R_{ON} of the transistors that form the selection switches (when on), as well as to the current flowing therein.

Consequently, the voltage on the node D is affected by imprecisions due not only to the variations in the technological process used to implement the transistors that form the selection switches 11, 12 and 13, but also, and above all, to the temperature; moreover, the higher the number of selection switches that form the column decoder 4, the less precise and controllable the voltage of the node D, both during programming and reading.

Furthermore, in the column decoding architecture shown in Figure 1, the noise present on the node A, on the node B or on the node C and mainly consisting of fluctuations of the electrical potentials of these nodes is transmitted as such to the node D, with evident disturbance on the operation that is being carried out, whether reading or programming.

The aforesaid two factors of disturbance and imprecision on the biasing voltages of the drain terminals of the memory cells, as previously mentioned, adversely affect not only the precision of the levels programmed in the memory cells, but also the corresponding programming time.

In addition, when the aim is to reduce the biasing voltage of the drain terminal of the addressed memory cell 7, for example to bring it to approximately 0.4 V, this problem becomes even more accentuated and may even jeopardize the sturdiness, if not indeed the feasibility, of nonvolatile memory devices having the aforesaid characteristics.

The aim of the present invention is to provide a nonvolatile memory device that is free from the drawbacks described above.

According to the present invention, a nonvolatile memory device is provided, as defined in claim 1.

For a better understanding of the present invention, some preferred embodiments thereof are now described, purely as non-limiting examples, with reference to the attached drawings, wherein:
- Figure 1 shows a circuit diagram of one part of a known nonvolatile memory device;
- Figure 2 shows a circuit diagram of one part of a nonvolatile memory device according to a first embodiment of the present invention; and
- Figure 3 shows a circuit diagram of one part of a nonvolatile memory device according to a second embodiment of the present invention.

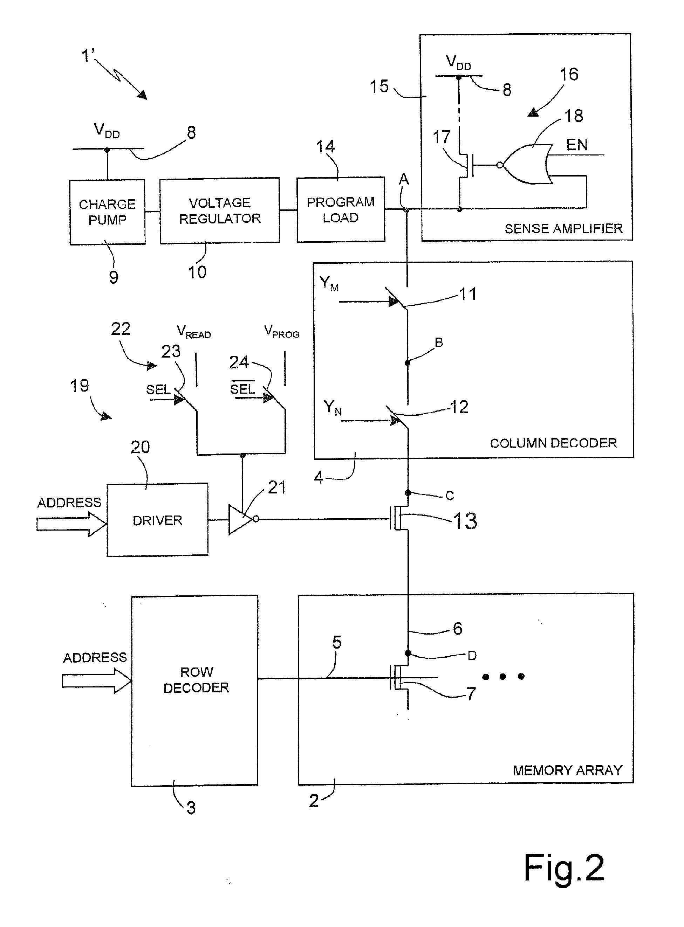

Figure 2 is a schematic representation of a nonvolatile memory device according to a first embodiment of the present invention and limitedly to the parts that are necessary for understanding the present invention. In Figure 2, the parts similar to those of Figure 1 are designated by the same reference numbers.

As shown in Figure 2, the nonvolatile memory device, designated as a whole by 1', differs from the nonvolatile memory device 1 of Figure 1 in that the drain terminal of the addressed memory cell 7 is biased by exploiting, as described in detail hereinafter, the selection switch of the column decoder 4 which is physically closest to the addressed memory cell 7, namely the selection switch that has its source terminal connected to the drain terminal of the memory cell 7, i.e., in the example illustrated the selection switch 13.

In particular, in order to obtain this, the selection switch 13 is formed by an NMOS transistor driven by a driving circuit 19 including a driving stage 20 and of an output buffer 21, which are cascaded together and generate a logic-type driving signal, the logic levels whereof are defined by respective regulated and stable voltages.

In detail, the driving signal is generated by the driving stage 20 according to the addresses supplied to the nonvolatile memory device 1' analogously to prior art nonvolatile memory devices, and is supplied to the selection switch 13 via the output buffer 21.

The selection switch 13 is formed by an NMOS transistor having its drain terminal connected to the selection switch 12, its source terminal connected to the drain terminal of the addressed memory cell 7, and its gate terminal connected to the output of the output buffer 21 and receiving the driving signal generated by the driving stage 20.

The selection transistor 13 may be either of traditional type or of a natural type, i.e., having a zero threshold voltage, or else may be a transistor with a controlled threshold voltage lower than a traditional NMOS transistor.

In addition, the output buffer 21 is supplied by a multiplexer 22 having a first and a second input which respectively receive the read voltage and the programming voltage that are to be supplied as required to the addressed memory cells and are generated in a known way (consequently not described in detail herein), a selection input receiving a logic-type selection signal SEL, and an output connected to a supply input of the output buffer 21 and selectively connectable to the first or to the second input according to the logic level assumed by the selection signal SEL.

In particular, the multiplexer 22 can be schematically represented by two switches 23, 24 which are controlled in phase opposition by the selection signal SEL and each of which is connected between a respective input and the output of the multiplexer 22.

The selection transistor 13 driven by a driving circuit of the type described above defines a cascoded structure which causes the voltage of the node D to be${\text{V}}_{\text{D}} {\text{= V}}_{\text{G}} {\text{- V}}_{\text{GS}} {\text{= V}}_{\text{G}} {\text{- (V}}_{\text{TH}} {\text{+ V}}_{\text{OV}} \text{)}$ where V_{G} is the biasing voltage of the gate terminal of the selection transistor 13, V_{GS} is the voltage between the gate and the source terminal of the selection transistor 13, V_{TH} is the threshold voltage of the selection transistor 13, and V_{OV} is the overdrive voltage of the selection transistor 13, which depends upon the current absorbed by the memory cell 7 addressed, as well as upon the size of the selection transistor 13.

Consequently, by virtue of the node D being cascoded by the selection transistor 13, the voltage of the node D depends exclusively upon the voltage supplied on the gate terminal of the selection transistor 13, and not upon the voltage of the node A or of any node intermediate to the column selectors.

By then appropriately biasing the gate terminal of the selection transistor 13 it is possible to bias, both during reading and programming, the drain terminal of the addressed memory cell 7 at the desired voltage, which is independent both of the voltage drops on the selection switches 11 and 12 of the column decoder 4 and of any ripples or fluctuations possibly present on all these nodes.

Consequently, the constraints on the stability and precision of the voltage of the node A are less stringent as compared to those of prior art nonvolatile memory devices, so that downstream of the charge pump 9 a voltage regulator 10 could be used having less marked characteristics of precision or regulation, or alternatively the voltage regulator could be omitted altogether, with the evident benefits that derive therefrom.

In addition, the precision and stability of the voltage of the node D depend exclusively upon the precision and stability of the voltage supplied on the gate terminal of the selection transistor 13 and generated by the driving stage 20, which can thus be designed in such a way as to ensure the required precision and stability. The dependence of the voltage of the node D upon the variations with temperature in the characteristics of the selection switches of the column decoder 4 is thus eliminated.

Furthermore, the presence of the cascoded structure according to the present invention renders practically superfluous the biasing stage 16 of the sense amplifier 15, which could thus be omitted with evident benefits in terms of reduction of area occupied on the silicon.

In addition, by appropriately designing the driving stage 20 according to the characteristics of the selection stage 13, it is possible to track the variations in the characteristics of the selection transistor 13 as the temperature varies, by suitably acting on the logic levels of the driving signal supplied on the gate terminal of the selection transistor 13.

It should moreover be emphasized that in the above mentioned embodiment of the invention the selection transistor 13 performs a dual function: its traditional function of addressing the columns of the memory array 2, together with the selection switches 11 and 12, in so far as the driving signal supplied by the driving stage 20 is generated according to the addresses supplied to the nonvolatile memory device 1', and a function of biasing the drain terminal of the addressed memory cell 7 at a precise and stable voltage which is independent of the voltage supplied by the voltage regulator 10 (this being a function of cascoding of the drain terminal of the addressed memory cell 7).

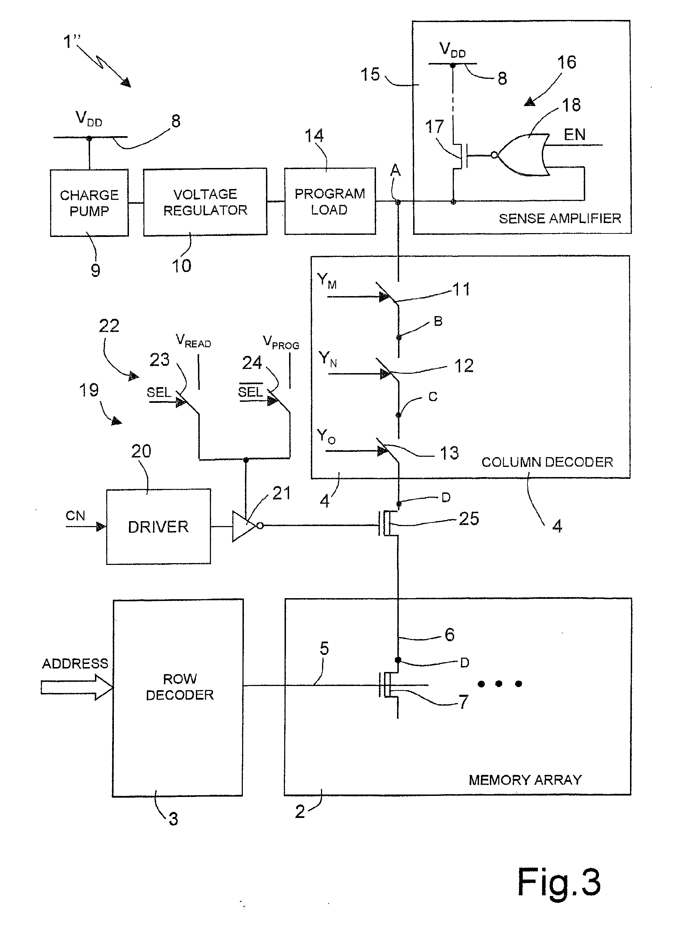

Figure 3 shows a different embodiment of the present invention, in which parts similar to those of Figure 2 are designated by the same reference numbers.

In particular, the nonvolatile memory device illustrated in Figure 3, designated by 1", differs from the nonvolatile memory device 1' in that cascoding of the node D is not obtained by exploiting the selection switch 13 of the column decoder 4 that is physically closest to the memory cell 7 addressed, but rather through a cascoding transistor, designated by 25, which is distinct from the transistors forming the selection switches 11, 12 and 13 and is arranged between the column decoder 4 and the addressed memory cell 7.

Furthermore, in the latter embodiment, the driving stage 20 no longer receives the addresses supplied to the nonvolatile memory device 1", but simply a control signal CN that indicates the operation, namely either reading or programming, that is to be carried out on the addressed memory cell 7. Addressing of the memory cells is in fact already completely carried out by the column decoder 4 according to the addresses in a traditional way, and consequently the driving signal generated by the driving stage 20 performs just the function of turning the cascoding transistor 13 on or off according to the operation, either reading or programming, that is to be carried out on the addressed memory cell 7.

It is moreover pointed out that in both of the embodiments of the present invention described above for cascoding the drain terminals of the memory cells it is necessary to provide a cascoding transistor for each bit line 6 of the memory array 2, whether the cascoding transistor is made by exploiting one of the selection transistors of the column decoder 4 or by using an additional transistor.

As regards, instead, the driving circuit 19, it is possible to envisage one circuit for each cascoding transistor, or else a same driving circuit 19 could drive simultaneously a plurality of cascoding transistors according to the degree of parallelism adopted during reading or writing, defined as the number of memory cells on which a same operation (reading or programming) is performed simultaneously.

In particular, as will be clarified hereinafter, this type of architecture makes it possible to perform simultaneously different operations, for example reading and programming, on different groups of memory cells belonging to a same word line, and this bestows on the nonvolatile memory device according to the invention a degree of flexibility of use which cannot be achieved by the nonvolatile memory devices according to the prior art.

In order to understand fully the above, consider the following example: assume that a degree of parallelism of 2 bytes (16 bits) is adopted, i.e., that the column decoding architecture allows simultaneous addressing of sixteen bit lines at a time, that the cascoding transistors associated to eight of the sixteen bit lines that can be addressed simultaneously are connected to a first driving stage 19, that the cascoding transistors associated to the remaining eight bit lines that can be addressed simultaneously are connected to a second driving stage 19, that the multiplexer 22 of the first driving stage 19 is controlled so as to supply the corresponding output buffer 21 with the read voltage V_{READ}, and that the multiplexer 22 of the second drive stage 19 is controlled so as to supply the corresponding output buffer 21 with the programming voltage V_{PROG}.

If one word line 5 of the memory array 2 and sixteen bit lines 6 are now addressed, with the architecture illustrated above it is possible to simultaneous read the eight addressed memory cells that are cascoded through the first biasing stage 19, and programming the addressed eight memory cells that are cascoded through the second biasing stage 19.

In fact, the gate terminals of the cascoding transistors connected to the first biasing stage 19, and thus the drain terminals of the memory cells connected thereto, are biased at the read voltage V_{READ}, thus enabling reading of these memory cells (reading of a first one of the two bytes), while the gate terminals of the cascoding transistors connected to the second biasing stage 19, and thus the drain terminals of the memory cells connected thereto, are biased at the programming voltage V_{PROG}, thus enabling programming of these memory cells (programming of the second one of the two bytes).

The architecture described above can obviously be extended to any degree of parallelism that it is desired to adopt, even to a degree of parallelism at the level of the individual bit.

Finally, it is clear that numerous modifications and variations may be made to the memory device described and illustrated herein, without thereby departing from the scope of the present invention, as defined in the attached claims.

For example, the selection transistor 13 or the cascoding transistor 25 could be driven through a driving circuit which has an architecture different from the one described, but which in any case generates a driving signal, the logic levels of which are defined by respective precise and stable voltages, and the values of which depend upon the voltage at which the drain terminal of the addressed memory cell is to be biased.

## Claims

1. A nonvolatile memory device (1'; 1") comprising a memory array (2) including a plurality of memory cells (7), row decoding means (3) and column decoding means (4) connected to said memory array (2) for addressing the memory cells (7), and biasing means (13, 19; 25, 19) for biasing a current conduction terminal of an addressed memory cell (7) connected to said column decoding means (4); **characterized in that** said biasing means (13, 19; 25, 19) are coupled between said column decoding means (4) and said memory array (2).

2. The nonvolatile memory device according to claim 1, **characterized in that** said biasing means (13, 19; 25, 19) are directly connected to said current conduction terminal of the addressed memory cell (7).

3. The nonvolatile memory device according to claim 1 or 2, **characterized in that** said biasing means (13, 19; 25, 19) have a cascode structure.

4. The nonvolatile memory device according to any of the foregoing claims, **characterized in that** said biasing means (13, 19; 25, 19) comprise biasing transistor means (13; 25) having a first current conduction terminal connected to said column decoding means (4) and a second current conduction terminal connected to said current conduction terminal of the addressed memory cell (7), and a control terminal receiving a driving signal of a logic type, the logic levels whereof are defined by respective precise and stable voltages.

5. The nonvolatile memory device according to claim 4, **characterized in that** said column decoding means (4) comprise a plurality of selection transistor means (11, 12, 13) connected in series, and **in that** said biasing transistor means are formed by the selection transistor means (13) that are closest to said memory cell (7).

6. The nonvolatile memory device according to claim 5, **characterized in that** said biasing transistor means are formed by the selection transistor means (13) that have a current conduction terminal directly connected to the addressed memory cell (7).

7. The nonvolatile memory device according to claim 4, **characterized in that** said column decoding means (4) comprise a plurality of selection transistor means (11, 12, 13) connected in series, and **in that** said biasing transistor means (25) are distinct from said selection transistor means (11, 12, 13).

8. The nonvolatile memory device according to any of claims 4 to 7, **characterized in that** said biasing transistor means (13, 19; 25, 19) further comprise driving means (19) connected to said control terminal of said biasing transistor means (13; 25) and generating said driving signal; said driving means (19) comprising a driving stage (20) and an output buffer (21) cascade-connected together, and a multiplexer (22) for supplying said output buffer (21), said multiplexer (22) having a first input biased at a first reference voltage (V_{READ}) and a second input biased at a second reference voltage (V_{PROG}), a selection input receiving a selection signal (SEL) of a logic type, and an output connected to a supply input of said output buffer (21) and selectively connectable to said first input and to said second input according to the logic level of the selection signal (SEL).

9. The nonvolatile memory device according to claim 8, **characterized in that** said biasing transistor means (13, 19; 25, 19) comprise a plurality of said biasing transistor means (13; 25); a first subset of said biasing transistor means (13; 25) having a control terminal connected to first driving means (19) that generate a first driving signal, and a second subset of said biasing transistor means (13; 25) having a control terminal connected to second driving means (19) that generate a second driving signal.

10. The nonvolatile memory device according to claim 9, **characterized in that** said memory array (2) comprises a plurality of bit lines (6), and **in that** said plurality of biasing transistor means (13; 25) comprises a biasing transistor (13; 25) for each bit line (6) of said memory array (2).
